(19) Europäisches Patentamt — European Patent Office — Office européen des brevets

(11) **EP 3 047 053 B1**

(12) **FASCICULE DE BREVET EUROPEEN**

(45) Date de publication et mention de la délivrance du brevet:
**15.11.2017 Bulletin 2017/46**

(21) Numéro de dépôt: **14786330.2**

(22) Date de dépôt: **16.09.2014**

(51) Int Cl.:
*C30B 11/00* (2006.01)    *C30B 29/06* (2006.01)

(86) Numéro de dépôt international:
**PCT/IB2014/064555**

(87) Numéro de publication internationale:
**WO 2015/040542 (26.03.2015 Gazette 2015/12)**

(54) **PROCEDE DE FABRICATION D'UN LINGOT DE SILICIUM PRESENTANT UNE CONCENTRATION HOMOGENE EN PHOSPHORE**

VERFAHREN ZUR HERSTELLUNG EINES SILICIUMBLOCKS MIT GLEICHMÄSSIGER PHOSPHORKONZENTRATION

METHOD FOR MANUFACTURING A SILICON INGOT HAVING UNIFORM PHOSPHORUS CONCENTRATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.09.2013 FR 1358935**

(43) Date de publication de la demande:
**27.07.2016 Bulletin 2016/30**

(73) Titulaire: **Commissariat à l'Énergie Atomique et aux Énergies Alternatives 75015 Paris (FR)**

(72) Inventeurs:
• **GARANDET, Jean-Paul**
  **92210 Saint-Cloud (FR)**
• **BENMANSOUR, Malek**
  **73290 La Motte Servolex (FR)**
• **JOUINI, Anis**
  **73000 Chambéry (FR)**
• **PELLETIER, David**
  **73490 La Ravoire (FR)**

(74) Mandataire: **Nony
11 rue Saint-Georges
75009 Paris (FR)**

(56) Documents cités:
**WO-A1-2008/131794    WO-A1-2013/051940
FR-A1- 2 968 127**

• **DHAMRIN ET AL.: "Realization of high minority carrier properties in low resistivity n-type multicrystralline silicon", THE COMPILED STATE-OF-THE-ART OF PV SOLAR TECHNOLOGY AND DEPLOYMENT : 22ND EUROPEAN PHOTOVOLTAIC SOLAR ENERGY CONFERENCE, EU PVSEC ; PROCEEDINGS OF THE INTERNATIONAL CONFERENCE, HELD IN MILAN, ITALY, 3 - 7 SEPTEMBER 2007, MUNICH : WIP-RENEWABLE ENERG, 3 septembre 2007 (2007-09-03), pages 1151-1154, XP040513175, ISBN: 978-3-936338-22-5**

**Description**

La présente invention se rapporte à un nouveau procédé de fabrication d'un lingot de silicium présentant une distribution homogène en phosphore.

Un tel lingot est particulièrement avantageux dans le cadre de l'élaboration de cellules photovoltaïques.

Actuellement, les cellules photovoltaïques sont majoritairement fabriquées à partir de silicium monocristallin ou polycristallin. La filière de production de silicium cristallin la plus courante met en jeu la solidification de lingots à partir d'un bain de silicium liquide contenu dans un creuset. Ces lingots sont ensuite découpés en plaquettes qui peuvent être alors transformées en cellules photovoltaïques.

La charge de silicium, utilisée comme matériau de départ pour la formation des lingots de silicium, est classiquement élaborée par un procédé de distillation d'un précurseur chloré, par exemple du trichlorosilane, obtenu à partir d'un silicium de grade métallurgique. Ce procédé permet une purification du silicium efficace, mais s'avère malheureusement coûteux en termes d'investissement financier et de consommation énergétique.

Différentes voies ont été explorées pour fabriquer une charge de silicium de grade solaire à partir de procédés relevant de la métallurgie, moins coûteux que les voies gazeuses.

A ce titre, les procédés de solidification directionnelle sont bien connus pour permettre une ségrégation des impuretés, et donc une purification des charges de départ.

Pour la purification du silicium, la technique de solidification directionnelle est particulièrement bien adaptée pour l'élimination des impuretés métalliques, comme le fer, le chrome, le nickel, etc., dont les coefficients de partage, notés k (défini comme le ratio entre la concentration en impureté dans la phase solide et la concentration dans la phase liquide à l'interface de solidification) sont très petits devant l'unité. Un faible coefficient de partage pour une impureté donnée permet ainsi d'envisager une purification du silicium par ségrégation de ladite impureté très efficace. Pour obtenir une ségrégation optimale, il est par ailleurs connu que le bain fondu doit être le plus homogène possible.

Dans le cas optimal d'un bain fondu homogène, la ségrégation d'une impureté peut être donnée par la loi de Scheil ($C(x) = k.C_0.(1-x)^{k-1}$, avec $C_0$ la concentration de l'impureté considérée dans le bain fondu avant le début de la cristallisation), qui relie la concentration $C(x)$ de ladite impureté dans le solide formé, et la fraction solidifiée x, *via* le coefficient de partage k de ladite impureté.

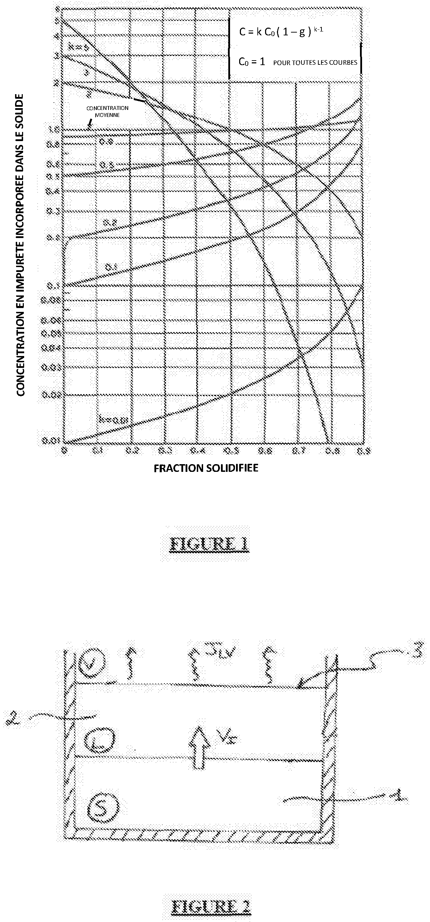

Les variations de la concentration en impureté incorporée dans le solide en fonction de la fraction solidifiée sont représentées en figure 1 [1] pour diverses valeurs de coefficient de partage. Il ressort des courbes représentées en figure 1, que la concentration en impureté incorporée dans le solide est susceptible de varier de manière conséquente au cours de la solidification du silicium, selon le coefficient de partage de l'impureté considérée.

De tels profils de concentration sont susceptibles de poser problème pour assurer une résistivité homogène des lingots de silicium destinés à une utilisation photovoltaïque. En effet, dans ces lingots de silicium, les teneurs en dopants de type p et de type n (éléments des colonnes III et V du tableau de classification périodique des éléments), dans la pratique, en phosphore et en bore, gouvernent la résistivité du silicium.

Pour ce qui est du bore, son coefficient de partage étant de 0,8, donc proche de l'unité, les variations de concentration en bore incorporé dans le silicium solidifié entre le bas et le haut du lingot restent acceptables.

En revanche, le phosphore possède un coefficient de partage plus faible, d'environ 0,35, ce qui induit des variations de concentration en phosphore conséquentes dans le silicium solidifié, et donc des variations de résistivité fortement préjudiciables pour l'élaboration des cellules photovoltaïques à partir de ces lingots de silicium. Le coefficient de partage du phosphore est par ailleurs trop élevé pour permettre une purification efficace par solidification dirigée des charges de silicium métallurgique, qui présentent généralement des teneurs en phosphore supérieures à 10 parties par million (ppm) en poids, et sont donc tout à fait impropres à la réalisation de cellules photovoltaïques.

Des procédés alternatifs pour l'élimination du phosphore ont été proposés, notamment par évaporation sous vide à haute température [2]. Cependant, sauf à tremper le liquide purifié, ce qui n'est pas acceptable du point de vue de la qualité cristalline du silicium solide requise pour des applications photovoltaïques, la concentration en phosphore ne peut être maintenue constante dans le silicium solidifié, du fait des mécanismes de ségrégation évoqués ci-dessus.

Ainsi, le contrôle des concentrations en phosphore dans les lingots de silicium reste problématique. Ce problème se pose particulièrement dans le cas des charges de silicium dites compensées, comportant à la fois des agents dopants de type n et de type p, pour lesquelles une absence de contrôle de la concentration en phosphore peut conduire à un changement du type de conductivité du silicium cristallisé au cours de la solidification dirigée, faisant ainsi chuter de façon significative la partie exploitable du lingot, et donc le rendement matière du procédé.

Par conséquent, il demeure un besoin de disposer d'une méthode, peu coûteuse, d'élaboration d'un lingot de silicium, permettant d'assurer une concentration homogène en phosphore, et par conséquent une résistivité homogène, dans le lingot formé.

La présente invention vise précisément à répondre à ce besoin.

Elle concerne ainsi, selon un premier de ses aspects, un procédé de fabrication d'un lingot de silicium présentant une concentration homogène en phosphore, comprenant au moins les étapes consistant en :

(i) disposer d'un bain quasi-homogène de silicium fondu comprenant au moins du phosphore ; et

(ii) procéder à la solidification directionnelle du silicium, avec une vitesse de solidification ($V_I$) du silicium et un flux d'évaporation ($J_{LV}$) du phosphore à l'interface liquide-vapeur du bain, contrôlés de manière à ce qu'à chaque instant de la solidification directionnelle, l'équation suivante soit vérifiée

$$V_I = k' / (2\text{-}k) \qquad (E)$$

k' représentant le coefficient de transfert du phosphore, et

k représentant le coefficient de partage du phosphore dans le silicium.

Les inventeurs ont ainsi découvert qu'il est possible d'assurer une teneur homogène en phosphore dans un lingot de silicium élaboré par un procédé classique de solidification directionnelle, *via* un contrôle simultané des cinétiques d'extraction de la chaleur et d'évaporation du phosphore.

Le document WO 2013/051940 vise à produire un lingot de silicium présentant une portion accrue de silicium de type p, à partir d'un bain de silicium comprenant du phosphore et du bore ; et propose d'éliminer de manière continue du phosphore du bain de silicium fondu. Ce document ne suggère nullement de contrôler la vitesse de solidification du silicium et le flux d'évaporation de manière à vérifier l'équation (E) selon l'invention à chaque instant de la solidification directionnelle.

Quant au document Dhamrin et al., "Realization of high minority carrier properties in low resistivity n-type multicrystalilne silicon", 22nd European Photovoltaic Solar Energy Conference, 3-7 September 2007, Milan, Italy, pages 1151-1154, il étudie l'influence du coefficient de ségrégation du phosphore sur les propriétés électriques d'un lingot de silicium de type n, par mesure de la résistivité et de la distribution des longueurs de diffusion. Dhamrin *et al.* ne suggèrent nullement un contrôle simultané des cinétiques d'extraction de la chaleur et d'évaporation du phosphore afin de satisfaire tout au long de la cristallisation l'équation (E) précitée.

Selon un autre de ses aspects, la présente invention concerne un lingot de silicium présentant, sur une hauteur d'au moins 20 cm, voire sur toute sa hauteur, une concentration homogène en phosphore.

Par distribution ou concentration « homogène » en phosphore, on entend caractériser le fait que les variations relatives de la concentration en phosphore dans le silicium solide sont inférieures ou égales à 20 %, de préférence inférieures ou égales à 10 %, et plus préférentiellement inférieures ou égales à 4 %.

La présente invention concerne encore un lingot de silicium susceptible d'être obtenu par le procédé défini précédemment.

Comme détaillé dans la suite du texte, un prétraitement d'évaporation partielle du phosphore peut être effectué pour abaisser la teneur en phosphore du bain de silicium fondu, avant d'initier la solidification, ce qui permet de porter la teneur en phosphore dans le lingot de silicium final à une valeur compatible avec une utilisation photovoltaïque.

De manière avantageuse, le procédé de l'invention permet ainsi de réaliser un lingot de silicium, qui présente une concentration maîtrisée en phosphore distribué de manière homogène au sein du lingot, particulièrement bien adapté à une découpe en plaquettes destinées à entrer directement dans un procédé de réalisation de cellules photovoltaïques.

Le procédé de l'invention peut encore être mis en oeuvre pour réaliser une charge de silicium de concentration homogène en phosphore, destinée à être refondue, par exemple dans un procédé de recristallisation.

Par ailleurs, le procédé de l'invention autorise avantageusement la mise en oeuvre de vitesses de solidification élevées, et permet donc d'atteindre des productivités satisfaisantes pour une application à l'échelle industrielle.

D'autres caractéristiques, avantages et modes d'application du procédé selon l'invention ressortiront mieux à la lecture de la description, de l'exemple et des figures qui vont suivre, donnés à titre illustratif et non limitatif.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression «comportant/comprenant un(e) » doit être comprise comme « comportant/comprenant au moins un(e) ».

## FABRICATION DU LINGOT DE SILICIUM

### Etape (i) : bain de silicium fondu

Comme précisé précédemment, l'étape (i) du procédé de l'invention consiste à disposer d'un bain quasi-homogène de silicium fondu, encore désigné comme bain « liquide », comprenant au moins du phosphore (P).

Par bain « quasi-homogène », on entend caractériser le fait que l'écart maximal de concentration en phosphore dans le bain de silicium liquide est inférieur ou égal à 20 %, de préférence inférieur ou égal à 15 %, et plus préférentiellement inférieur ou égal à 10 %.

Selon un mode de réalisation particulier, le bain fondu peut comprendre en outre au moins un agent dopant de type p, en particulier du bore.

La préparation du bain de silicium fondu mis en oeuvre en étape (i) du procédé de l'invention relève des connaissances générales de l'homme du métier.

Dans un mode préférentiel de réalisation, la charge de silicium peut être constituée de cailloux de silicium de qualité métallurgique, extraite par exemple directement des fours de réduction de silice, ou encore purifiée préalablement par traitement plasma ou affinage.

Dans un autre mode de réalisation, le bain fondu peut être formé au préalable par introduction dans un creuset, en phase solide, de plaquettes de silicium dopées en phosphore, et le cas échéant, de plaquettes de silicium dopées de type p, suivi du chauffage de l'ensemble à une température supérieure à la température de fusion du silicium.

Le bain de silicium fondu peut être réalisé dans un creuset en silice ou en graphite (éventuellement recouvert d'une couche de SiC). Les creusets sont connus pour résister à un chauffage à des températures élevées adéquates pour obtenir le bain fondu.

Le bain fondu mis en oeuvre en étape (i) peut comprendre une concentration en phosphore inférieure ou égale à 50 ppm, en particulier inférieure ou égale à 25 ppm, notamment inférieure ou égale à 5 ppm, et plus particulièrement comprise entre 0,3 et 3 ppm.

Selon une variante de réalisation, le bain de silicium fondu peut être soumis, préalablement à sa mise en oeuvre en étape (i) du procédé de l'invention, à un traitement thermique propice à l'évaporation partielle du phosphore de la charge initiale. Ce pré-traitement permet avantageusement d'abaisser la teneur en phosphore du bain fondu, en vue d'obtenir une concentration en phosphore dans le lingot final compatible avec une utilisation photovoltaïque.

L'homme du métier est à même de mettre en oeuvre un traitement thermique adéquat pour l'évaporation partielle du phosphore, par exemple en soumettant pendant une durée déterminée la charge de silicium fondu initiale à un gradient de température, à des températures et pression ajustées pour favoriser l'évaporation du phosphore, comme illustré dans l'exemple qui suit.

Bien entendu, il appartient à l'homme du métier d'adapter le volume du bain de silicium fondu mis en oeuvre en étape (i) du procédé de l'invention, au regard des dimensions du lingot de silicium souhaité.

Le bain de silicium fondu peut être agité, préalablement à sa mise en oeuvre en étape (ii) et/ou au cours de la solidification directionnelle en étape (ii) détaillée ci-dessous, à l'aide d'un système de brassage, pour assurer une bonne homogénéité du bain, en particulier une dispersion homogène du phosphore dans le bain de silicium fondu.

Le système de brassage peut consister par exemple en un brassage magnétique, brassage par table vibrante, brassage par ultrasons ou par pales mécaniques, etc.

**Etape (ii) : solidification directionnelle du silicium**

Dans une seconde étape du procédé de l'invention, il est procédé à la solidification directionnelle du silicium, en contrôlant simultanément la vitesse de solidification, notée $V_I$, du silicium et le flux d'évaporation, noté $J_{LV}$, du phosphore à l'interface liquide-vapeur du bain, de telle sorte à ce qu'à chaque instant de la solidification directionnelle, l'équation suivante soit vérifiée :

$$V_l = k' / (2-k) \qquad (E)$$

k' représentant le coefficient de transfert du phosphore, et
k représentant le coefficient de partage du phosphore dans le silicium.

Les deux paramètres, $V_I$ et $J_{LV}$, à contrôler au cours de la solidification directionnelle du silicium dans le procédé de l'invention, sont représentés, de manière schématique, en figure 2.

D'une manière générale, les méthodes de solidification directionnelle font appel, soit à un procédé de tirage, par exemple, par la méthode de tirage Czochralski ou encore la méthode dite de Bridgman, soit à un procédé par refroidissement progressif du bain liquide, contenu dans un récipient, en particulier un creuset, en dessous de son point de fusion, à partir de l'une de ses extrémités, jusqu'à solidification.

De préférence, la solidification directionnelle en étape (ii) est opérée par une méthode de refroidissement sous gradient, encore connue sous l'appellation « gradient freeze » en langue anglaise.

Il relève des connaissances générales de l'homme du métier de mettre en oeuvre l'appareillage adapté à la méthode de solidification directionnelle choisie.

D'une manière générale, dans la technique dite « gradient freeze », les lingots sont cristallisés dans un four de solidification directionnelle à l'intérieur duquel le refroidissement est piloté par la diminution de la puissance délivrée à la phase liquide ou l'augmentation de la puissance prélevée au lingot solide. Le déplacement de l'interface solide (1)/ liquide (2) dans le creuset provient de la modulation de la chaleur délivrée et de la chaleur extraite dans les différentes parties du creuset.

L'homme du métier est à même de contrôler et d'ajuster les valeurs de la vitesse de solidification $V_I$ du silicium et du flux d'évaporation $J_{LV}$ du phosphore à l'interface (3) liquide-vapeur du bain, de manière à satisfaire l'équation (E) précitée, et ainsi assurer une incorporation constante du phosphore au sein du silicium solidifié (1) lors de la solidification dirigée.

Selon une première variante de réalisation de l'invention, le flux d'évaporation du phosphore $J_{LV}$ est maintenu constant au cours de la solidification directionnelle en étape (ii), la vitesse de solidification du silicium $V_I$ étant ajustée de manière adéquate au cours de la solidification directionnelle pour satisfaire l'équation (E) précitée et ainsi garantir une distribution homogène du phosphore au sein du silicium solidifié.

Selon une seconde variante de réalisation de l'invention, la solidification directionnelle en étape (ii) est opérée à vitesse de solidification du silicium constante, le flux d'évaporation du phosphore $J_{LV}$ étant ajusté de manière adéquate au cours de la solidification directionnelle pour satisfaire l'équation (E) précitée et ainsi garantir une distribution homogène du phosphore au sein du silicium solidifié.

Selon un mode de réalisation particulier, le flux d'évaporation du phosphore $J_{LV}$ en étape (ii) peut être contrôlé *via* un ajustement du coefficient de transfert k' du phosphore.

Sans vouloir être lié par la théorie, le flux d'évaporation du phosphore $J_{LV}$ (exprimé en moles par unité de surface et de temps) peut être relié au coefficient de transfert du phosphore, k', encore appelée « constante d'évaporation » (exprimé en m/s), par la relation : $J_{LV} = k' \times C$, avec C la concentration en phosphore dans le bain liquide à l'interface (3) liquide-vapeur. Le coefficient de transfert k' dépend notamment de la température de l'interface liquide-vapeur (3) du bain fondu, et de la pression dans l'enceinte du four de solidification directionnelle utilisé.

Ainsi, le flux d'évaporation du phosphore $J_{LV}$ (et le coefficient de transfert du phosphore k') peut être maîtrisé en ajustant la température de l'interface liquide-vapeur du bain fondu et/ou la pression dans l'enceinte du four de solidification directionnelle.

A titre d'exemple, le coefficient de transfert k' du phosphore en étape (ii) peut être compris entre $1,5.\,10^{-6}$ et $3.10^{-5}$ m/s, en particulier entre $8.10^{-6}$ et $1,5.10^{-5}$ m/s.

Quant à la vitesse de solidification du silicium $V_I$, elle peut être contrôlée *via* un ajustement du flux de chaleur dans le four de solidification directionnelle utilisé, en particulier par extraction contrôlée de la chaleur.

A titre d'exemple, la vitesse moyenne de solidification du silicium $V_I$ en étape (ii) peut être comprise entre 1 et 20 $\mu$m/s, en particulier entre 5 et 10 $\mu$m/s.

De même, il relève des connaissances générales de l'homme du métier d'adapter de manière adéquate les moyens et conditions opératoires du four de solidification directionnelle employé, pour moduler le flux de chaleur lors de la solidification directionnelle en étape (ii).

Différents moyens de chauffage (par exemple résistif ou inductif) ou d'extraction de la chaleur peuvent être utilisés. A titre d'exemple, le flux de chaleur dans le four de solidification directionnelle peut être modulé par une extraction contrôlée de chaleur par le fond du creuset, par exemple à l'aide d'un échangeur de chaleur à conductivité thermique ajustable, comme proposé dans le document FR 2 968 127, ou tout autre système connu de l'homme du métier pour permettre une régulation du flux de chaleur extrait.

De préférence, le phosphore est dispersé de manière quasi-homogène dans le bain de silicium fondu (2) au cours de la solidification directionnelle.

Comme évoqué précédemment, selon un mode de réalisation particulier, le bain fondu peut être maintenu sous agitation, à l'aide d'un système de brassage, au cours de la solidification directionnelle, pour assurer une bonne homogénéité du bain de silicium fondu.

Comme illustré dans l'exemple 1 qui suit, le contrôle simultané de la vitesse de solidification du silicium ($V_I$) et du flux d'évaporation ($J_{LV}$) du phosphore, pour satisfaire l'équation $V_I = k' / (2-k)$ (E), permet d'atteindre une répartition homogène en phosphore dans le lingot solidifié.

Sans vouloir être lié par la théorie, pour obtenir une distribution homogène du phosphore au sein du silicium solidifié, il convient de s'assurer, tout au long de la solidification dirigée, que dC/dt=0 *(équation 1)*, avec C représentant la concentration en phosphore dans un bain fondu homogène.

La concentration C en phosphore dans un bain homogène pouvant s'exprimer sous la forme :

$$C = Q / (S \times h)$$

avec Q la quantité totale de phosphore dans le bain exprimée en moles, S la section droite du creuset contenant le bain de silicium fondu, et h la hauteur du bain qui varie au cours de la solidification dirigée, l'équation 1 précitée peut s'exprimer sous la forme :

$$dQ/dt \times h - Q \times dh/dt = 0 \qquad \textit{(équation 2),}$$

avec $dh/dt = - V_l$, $V_l$ représentant la vitesse de solidification du silicium.

D'autre part, en considérant qu'entre t et t + dt de la solidification dirigée, la quantité de phosphore dans le bain est augmentée par le mécanisme de rejet du phosphore à l'interface solide-liquide, et simultanément diminuée par le mécanisme d'évaporation du phosphore à l'interface liquide-vapeur, on peut considérer que :

$$dQ/dt = [V_l \times (1-k) \times C - J_{LV}] \times S \qquad \textit{(équation 3)}$$

avec k le coefficient de partage du phosphore dans le silicium, voisin de 0,35, $J_{LV}$ le flux d'évaporation du phosphore à l'interface liquide-vapeur du bain (exprimé en moles par unité de surface et de temps).

En exprimant $J_{LV}$ sous la forme $J_{LV} = k' \times C$, avec k' le coefficient de transfert du phosphore (exprimé en m/s), l'équation 2 précitée s'exprime ainsi par :

$$V_l = k' / (2-k) \qquad \textit{(équation (E)).}$$

Ainsi, dans le cas d'un bain quasi-homogène, il est possible de garantir une distribution homogène du phosphore au sein du silicium solidifié, en ajustant la vitesse de solidification $V_l$ du silicium et le flux d'évaporation du phosphore $J_{LV}$ (soit la constante d'évaporation k' du phosphore), de telle sorte qu'à chaque instant de la solidification directionnelle, l'équation (E) précitée soit vérifiée.

D'autres variantes d'application du procédé de l'invention, par exemple à partir d'un bain de silicium inhomogène, peuvent être envisagées, sans se départir de l'esprit de l'invention.

Bien entendu, la vitesse de solidification ($V_l$) du silicium et le flux d'évaporation du phosphore ($J_{LV}$) seront alors contrôlés, pour garantir une distribution homogène du phosphore au sein du silicium solidifié, suivant des équations de contrôle différentes selon les caractéristiques du bain de silicium fondu et les conditions de mise en oeuvre de la solidification dirigée.

Ainsi, d'une manière générale, la présente invention propose d'accéder à un lingot de silicium présentant une concentration homogène en phosphore, à partir d'un bain de silicium fondu comprenant au moins du phosphore, en procédant à la solidification directionnelle du silicium, avec une vitesse de solidification ($V_l$) du silicium et un flux d'évaporation ($J_{LV}$) du phosphore à l'interface liquide-vapeur du bain contrôlés pour garantir une distribution homogène du phosphore au sein du silicium solidifié.

## LINGOT DE SILICIUM

Comme vu précédemment, la présente invention concerne, selon un autre de ses aspects, un lingot de silicium présentant, sur une hauteur d'au moins 20 cm, voire sur toute sa hauteur, une concentration homogène en phosphore.

Un tel lingot peut être plus particulièrement obtenu *via* le procédé de solidification directionnelle décrit précédemment.

Par concentration « homogène » en phosphore, on entend plus particulièrement caractériser le fait que les variations relatives de la concentration en phosphore sur la hauteur du lingot de silicium considérée, sont inférieures ou égales à 20 %, en particulier inférieures ou égales à 10 %, et plus préférentiellement inférieures ou égales à 4 %.

La distribution du phosphore au sein du lingot de silicium peut être évaluée par une mesure des variations de résistivité. La résistivité peut être mesurée par toute méthode conventionnelle connue de l'homme du métier, comme par exemple, par la mesure dite des quatre pointes, ou encore par mesure de l'effet des courants de Foucault induits par un champ magnétique alternatif.

La distribution du phosphore au sein du silicium solidifié peut encore être déterminée par la technique de spectrométrie de masse à décharge luminescente (« Glow Discharge Mass Spectroscopy » (GDMS) en langue anglaise).

Selon un mode de réalisation particulièrement préféré, le lingot présente une teneur homogène en phosphore sur toute sa hauteur.

Ledit lingot de silicium peut plus particulièrement présenter une hauteur comprise entre 10 cm et 1 m, en particulier comprise entre 20 et 50 cm.

La hauteur du lingot s'entend de la dimension du lingot selon l'axe (z) d'un référentiel orthogonal d'axes (x), (y), (z), l'axe (z) étant colinéaire à la direction de solidification du silicium lors de la fabrication du lingot.

La concentration en phosphore, distribué de manière homogène au sein du lingot de silicium, peut être notamment inférieure ou égale à 20 ppm, en particulier inférieure ou égale à 5 ppm et plus particulièrement comprise entre 0,1 et 2 ppm.

Après éboutage standard des zones périphériques du lingot, ce dernier peut être découpé en briques selon des techniques connues de l'homme du métier. Des plaquettes de silicium peuvent être ensuite élaborées à partir de ces briques, selon des techniques classiques connues de l'homme du métier, notamment par découpe des briques, rectification des faces, éboutages des extrémités haute et basse, pour ajuster les dimensions de la plaquette, etc..

Comme évoqué précédemment, ces plaquettes, présentant une teneur homogène en phosphore, et donc une résistivité homogène, peuvent avantageusement être utilisées directement pour l'élaboration de cellules photovoltaïques.

## FIGURES

Figure 1 : courbes, établies selon la loi de Scheil, de variation de la concentration en espèce incorporée dans le solide en fonction de la fraction solidifiée pour diverses valeurs du coefficient de partage k ;

Figure 2: représentation schématique des paramètres contrôlés, vitesse de solidification du silicium $V_l$ et flux d'évaporation du phosphore $J_{LV}$, à un instant donné de la solidification directionnelle du silicium selon le procédé de l'invention.

L'invention va maintenant être décrite au moyen de l'exemple suivant, donné à titre illustratif et non limitatif de l'invention.

## EXEMPLE

Une charge de silicium d'environ 60 kg, sous forme de cailloux de dimensions centimétriques, est introduite dans un creuset graphite revêtu d'une couche de carbure de Si de dimensions intérieures 39x39x39 cm, sur lequel un revêtement anti-adhérent de nitrure de silicium avait été préalablement déposé. La teneur en phosphore de la charge est de 15 ppm poids, mesurée par la technique de Glow Discharge Mass Spectroscopy.

L'ensemble est ensuite introduit dans le dispositif de solidification, un four vertical de technologie « gradient freeze », avec des éléments chauffants (résistors graphite) situés en partie haute et sur les côtés du creuset.

*Abaissement de la concentration en phosphore*

Le silicium est d'abord soumis à une montée en température pour assurer sa fusion complète, et on impose un gradient de 10 K/cm sur la hauteur du bain, dont le sommet est maintenu à une température de 1 650°C et le fond à une température voisine de 1 410°C pendant environ trois heures à une pression de $5 \times 10^{-3}$ mbar pour favoriser l'évaporation du phosphore et ramener la concentration en phosphore du bain à une valeur de 2 ppm poids.

*Solidification directionnelle du silicium*

La température en partie chaude (température de l'interface liquide-vapeur) est maintenue égale à 1 650°C durant toute la solidification ; le coefficient de transfert k' du phosphore est ainsi maintenu constant au cours de la solidification directionnelle.

La convection naturelle dans le bain fondu est suffisante pour que celui-ci puisse être considéré comme un bain quasi-homogène.

La vitesse de solidification du silicium est ajustée pour satisfaire l'équation $V_l=k'/(2-k)$ (E), avec k le coefficient de partage du phosphore dans le silicium, d'environ 0,35.

La croissance du silicium est initiée par le biais de l'ouverture de volets isolants. L'ouverture progressive des volets isolants permet de contrôler la chaleur à évacuer tout au long du processus.

La solidification complète du bain liquide de 22 cm de hauteur est réalisée en 10 heures environ, la vitesse moyenne de solidification est donc 2,2 cm/h (6 $\mu$m/s). En régime de croissance, la puissance consommée par le four est d'environ 38 kW. La puissance de chauffe est ensuite réduite et le lingot ramené à température ambiante et démoulé du creuset.

*Résultat*

Une analyse des variations de la résistivité au sein du lingot de silicium, par la mesure dite des 4 pointes, permet de vérifier que le phosphore est réparti de manière homogène dans le lingot.

Références

[1] W.G. Pfann, "Zone melting" (2nd édition), Wiley, New York 1966;
[2] S.S Zheng et al., "Mass Transfer of Phosphorus in Silicon Melts Under Vacuum Induction Refining", Metall. Mat. Trans. B, 41B (2010) 1268-1273.

**Revendications**

1. Procédé de fabrication d'un lingot de silicium présentant une concentration homogène en phosphore, comprenant au moins les étapes consistant en :

   (i) disposer d'un bain quasi-homogène de silicium fondu comprenant au moins du phosphore ; et
   (ii) procéder à la solidification directionnelle du silicium, avec une vitesse de solidification ($V_I$) du silicium et un flux d'évaporation ($J_{LV}$) du phosphore à l'interface liquide-vapeur du bain contrôlés de manière à ce qu'à chaque instant de la solidification directionnelle, l'équation suivante soit vérifiée

$$V_I = k' / (2-k) \quad \text{en m/s} \quad (E)$$

   k' représentant le coefficient de transfert du phosphore, en m/s et
   k représentant le coefficient de partage du phosphore dans le silicium

   et $J_{LV} = k' \times C$ en moles/ $m^2$.s
   C représentant la concentration en phosphore dans le bain liquide à l'interface liquide-vapeur.

2. Procédé selon la revendication 1, dans lequel le bain de silicium subit, préalablement à sa mise en oeuvre en étape (i), un traitement thermique propice à l'évaporation partielle du phosphore.

3. Procédé selon la revendication 1 ou 2, dans lequel le phosphore est présent dans le bain fondu en étape (i) en une concentration inférieure ou égale à 50 ppm, en particulier inférieure ou égale à 25 ppm, notamment inférieure ou égale à 5 ppm, et plus particulièrement comprise entre 0,3 et 3 ppm.

4. Procédé selon l'une quelconque des revendications précédentes, dans lequel le bain fondu est agité, préalablement à sa mise en oeuvre en étape (ii) et/ou au cours de la solidification en étape (ii), à l'aide d'un système de brassage, pour assurer une dispersion quasi-homogène du phosphore dans le bain de silicium fondu.

5. Procédé selon l'une quelconque des revendications précédentes, dans lequel l'étape (ii) de solidification du silicium est opérée par une méthode de refroidissement sous gradient.

6. Procédé selon l'une quelconque des revendications précédentes, dans lequel le flux d'évaporation du phosphore ($J_{LV}$) en étape (ii) est contrôlé *via* un ajustement du coefficient de transfert (k') du phosphore, en particulier en ajustant la température de l'interface liquide-vapeur du bain fondu et/ou la pression dans l'enceinte du four de solidification directionnelle utilisé.

7. Procédé selon l'une quelconque des revendications précédentes, dans lequel la vitesse de solidification du silicium ($V_I$) en étape (ii) est contrôlée *via* un ajustement du flux de chaleur dans le four de solidification directionnelle utilisé, en particulier par extraction contrôlée de la chaleur.

8. Procédé selon l'une quelconque des revendications précédentes, dans lequel la vitesse moyenne de solidification

($V_l$) du silicium en étape (ii) est comprise entre 1 et 20 $\mu$m/s, en particulier entre 5 et 10 $\mu$m/s.

9. Procédé selon l'une quelconque des revendications précédentes, dans lequel le coefficient de transfert k' du phosphore en étape (ii) est compris entre $1,5.10^{-6}$ et $3.10^{-5}$, en particulier entre $8.10^{-6}$ et $1,5.10^{-5}$ m/s.

10. Procédé selon l'une quelconque des revendications précédentes, dans lequel le flux d'évaporation du phosphore ($J_{LV}$) est maintenu constant au cours de la solidification directionnelle en étape (ii), la vitesse de solidification du silicium ($V_l$) étant ajustée pour satisfaire l'équation (E).

11. Lingot de silicium présentant, sur une hauteur d'au moins 20 cm, une concentration homogène en phosphore, les variations relatives de la concentration en phosphore sur la hauteur du lingot de silicium considérée étant inférieures ou égales à 20 %, en particulier inférieures ou égales à 10 % et plus particulièrement inférieures ou égales à 4 %.

12. Lingot selon la revendication 11, ladite concentration en phosphore étant inférieure ou égale à 20 ppm, en particulier inférieure ou égale à 5 ppm et plus particulièrement comprise entre 0,1 et 2 ppm.

13. Lingot selon la revendication 11 ou 12, présentant une concentration homogène en phosphore sur toute sa hauteur, ledit lingot présentant notamment une hauteur comprise entre 10 cm et 1 m, plus particulièrement comprise entre 20 et 50 cm.

## Patentansprüche

1. Verfahren zur Herstellung eines Siliziumblocks, der eine homogene Phosphorkonzentration aufweist, mit wenigstens den Schritten die bestehen in:

  (i) Bereitstellen eines quasi-homogenen Bades aus geschmolzenem Silizium, das wenigstens Phosphor enthält, und
  (ii) gerichtetes Erstarren des Siliziums, mit einer Erstarrungsgeschwindigkeit ($V_l$) des Siliziums und einen Verdampfungsfluss ($J_{LV}$) des Phosphors an der Flüssigkeits/Dampf-Grenze des Bades, die so kontrolliert werden, dass in jedem Augenblick der gerichteten Erstarrung die folgende Gleichung erfüllt ist:

$$V_l = k' / (2-k) \text{ in m/s} \qquad (E)$$

  wobei k' den Transferkoeffizienten des Phosphors in m/s angibt und
  k den Verteilungkoeffizienten des Phosphors in dem Silizium angibt, und $J_{LV} = k' \times C$ in mol/$m_2 \cdot$ s

  wobei C die Konzentration des Phosphors in dem flüssigen Bad an der Flüssigkeits/Dampf-Grenze angibt.

2. Verfahren nach Anspruch 1, bei dem das Siliziumbad vor der Ausführung des Schrittes (i) eine thermische Behandlung erfährt, die günstig für eine teilweise Verdampfung des Phosphors ist.

3. Verfahren nach Anspruch 1 oder 2, bei dem das Phosphor in dem geschmolzenen Bad in Schritt (i) in einer Konzentration kleiner oder gleich 50 ppm, insbesondere kleiner oder gleich 25 ppm, weiter insbesondere kleiner oder gleich 5 ppm und noch weiter insbesondere zwischen 0,3 und 3 ppm enthalten ist.

4. Verfahren nach einem der vorstehenden Ansprüche, bei dem das geschmolzene Bad vor der Ausführung des Schrittes (ii) und/oder während der Erstarrung in Schritt (ii) mit Hilfe eines Rührsystems gerührt wird, um eine quasihomogene Dispersion des Phosphors in dem Bad aus geschmolzenem Silizium sicherzustellen.

5. Verfahren nach einem der vorstehenden Ansprüche, bei dem der Schritt (ii) der Erstarrung des Siliziums nach einem Verfahren der Gradientenkühlung ausgeführt wird.

6. Verfahren nach einem der vorstehenden Ansprüche, bei dem der Verdampfungsfluss ($J_{LV}$) des Phosphors in Schritt (ii) durch eine Einstellung des Transferkoeffizienten (k') des Phosphors kontrolliert wird, insbesondere durch Einstellung der Temperatur der Flüssigkeits/Dampf-Grenze des geschmolzenen Bades und/oder des Druckes in der Umhüllung des Ofens, der für die gerichtete Erstarrung verwendet wird.

7. Verfahren nach einem der vorstehenden Ansprüche, bei dem die Erstarrungsgeschwindigkeit ($V_I$) des Siliziums in Schritt (ii) durch eine Einstellung des Wärmeflusses in dem Ofen kontrolliert wird, der für die gerichtete Erstarrung verwendet wird, insbesondere durch kontrollierte Wärmeabfuhr.

8. Verfahren nach einem der vorstehenden Ansprüche, bei dem die mittlere Erstarrungsgeschwindigkeit ($V_I$) des Siliziums in Schritt (ii) zwischen 1 und 20 $\mu$m/s, insbesondere zwischen 5 und 10 $\mu$m/s beträgt.

9. Verfahren nach einem der vorstehenden Ansprüche, bei dem der Transferkoeffizient k' des Phosphors in Schritt (ii) zwischen 1,5 $10^{-6}$ und 3 $10^{-5}$, insbesondere zwischen 8 · $10^{-6}$ und 1,5 · $10^{-5}$ m/s liegt.

10. Verfahren nach einem der vorstehenden Ansprüche, bei dem der Verdampfungsfluss ($J_{LV}$) des Phosphors während der gerichteten Erstarrung in Schritt (ii) konstant gehalten wird, wobei die Erstarrungsgeschwindigkeit ($V_I$) so eingestellt wird, dass die Gleichung (E) erfüllt wird.

11. Siliziumblock, der auf einer Höhe von wenigstens 20 cm eine homogene Phosphorkonzentration aufweist, wobei die relativen Schwankungen der Phosphorkonzentration auf der betrachteten Höhe des Siliziumblockes kleiner oder gleich 20%, insbesondere kleiner oder gleich 10% und weiter insbesondere kleiner oder gleich 4% sind.

12. Siliziumblock nach Anspruch 11, bei dem die Phosphorkonzentration kleiner oder gleich 20 ppm, insbesondere kleiner oder gleich 5 ppm ist und weiter insbesondere zwischen 0,1 und 2 ppm liegt.

13. Siliziumblock nach Anspruch 11 oder 12, der auf seiner gesamten Höhe eine homogene Phosphorkonzentration aufweist, wobei der Siliziumblock insbesondere eine Höhe zwischen 10 cm und 1 m, weiter insbesondere zwischen 20 und 50 cm hat.

## Claims

1. A process for manufacturing a silicon ingot having a uniform phosphorus concentration, comprising at least the steps consisting in:

   (i) providing an almost uniform bath of molten silicon comprising at least phosphorus; and
   (ii) carrying out the directional solidification of the silicon, with a speed of solidification ($V_I$) of the silicon and a rate of evaporation ($J_{LV}$) of the phosphorus at the liquid-vapor interface of the bath which are controlled such that, at each moment of the directional solidification, the following equation is verified:

$$V_I = k' / (2\text{-}k) \qquad \text{in m/s} \qquad \text{(E)}$$

   k' representing the phosphorus transfer coefficient in m/s , and
   k representing the partition coefficient of the phosphorus in the silicon,

   and $J_{LV} = k' \times C$ in moles/m$^2$.s
   with C being the phosphorus concentration in the liquid bath at the liquid-vapor interface.

2. The process as claimed in claim 1, wherein the silicon bath undergoes, prior to its use in step (i), a heat treatment conducive to the partial evaporation of the phosphorus.

3. The process as claimed in claim 1 or 2, wherein the phosphorus is present in the molten bath in step (i) in a concentration of less than or equal to 50 ppm, in particular less than or equal to 25 ppm, especially less than or equal to 5 ppm, and more particularly of between 0.3 and 3 ppm.

4. The process as claimed in any one of the preceding claims, wherein the molten bath is stirred, prior to its use in step (ii) and/or during the solidification in step (ii), using a stirring system, so as to ensure almost uniform dispersion of the phosphorus in the bath of molten silicon.

5. The process as claimed in any one of the preceding claims, wherein the silicon solidification step (ii) is carried out by means of a gradient freeze method.

6. The process as claimed in any one of the preceding claims, wherein the phosphorus evaporation rate ($J_{LV}$) in step (ii) is controlled *via* an adjustment of the phosphorus transfer coefficient (k'), in particular by adjusting the temperature of the liquid-vapor interface of the molten bath and/or the pressure in the chamber of the directional solidification furnace used.

7. The process as claimed in any one of the preceding claims, wherein the silicon solidification speed ($V_I$) in step (ii) is controlled *via* an adjustment of the heat flow in the directional solidification furnace used, in particular by controlled extraction of the heat.

8. The process as claimed in any one of the preceding claims, wherein the average silicon solidification speed ($V_I$) in step (ii) is between 1 and 20 $\mu$m/s, in particular between 5 and 10 $\mu$m/s.

9. The process as claimed in any one of the preceding claims, wherein the phosphorus transfer coefficient k' in step (ii) is between $1.5 \times 10^{-6}$ and $3 \times 10^{-5}$, in particular between $8 \times 10^{-6}$ and $1.5 \times 10^{-5}$ m/s.

10. The process as claimed in any one of the preceding claims, wherein the phosphorus evaporation rate ($J_{LV}$) is kept constant during the directional solidification in step (ii), the silicon solidification speed ($V_I$) being adjusted so as to satisfy the equation (E).

11. A silicon ingot having a uniform phosphorus concentration across a height of at least 20 cm, the relative variations in the phosphorus concentration across the height of the silicon ingot under consideration being less than or equal to 20%, in particular less than or equal to 10%, and more preferentially less than or equal to 4%.

12. The ingot as claimed in claim 11, said phosphorus concentration being less than or equal to 20 ppm, in particular less than or equal to 5 ppm and more particularly between 0.1 and 2 ppm.

13. The ingot as claimed in claim 11 or 12, having a uniform phosphorus concentration across its entire height, said ingot having in particular a height of between 10 cm and 1 m, more particularly of between 20 and 50 cm.

$$C = k\,C_0\,(\,1 - g\,)^{\,k-1}$$

$$C_0 = 1 \quad \text{POUR TOUTES LES COURBES}$$

FIGURE 1

FIGURE 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013051940 A
- FR 2968127

**Littérature non-brevet citée dans la description**

- **DHAMRIN et al.** Realization of high minority carrier properties in low resistivity n-type multicrystalilne silicon. *22nd European Photovoltaic Solar Energy Conference,* 03 Septembre 2007, 1151-1154
- **W.G. PFANN.** Zone melting. Wiley, 1966
- **S.S ZHENG et al.** Mass Transfer of Phosphorus in Silicon Melts Under Vacuum Induction Refining. *Metall. Mat. Trans. B,* 2010, vol. 41B, 1268-1273